# EUROPÄISCHE PATENTANMELDUNG

(11) **EP 2 565 744 A2**
(43) Veröffentlichungstag der Anmeldung: **06.03.2013**
(21) Anmeldenummer: 12182370.2
(22) Anmeldetag: 30.08.2012
(51) Int. Cl.: G06F 1/18, H05K 7/14

(54) **Ankopplungsvorrichtung zum Ankoppeln von Rechnern**

(30) Priorität: 01.09.2011 CH 14262011
(71) Anmelder: Job Factory Basel AG, 4053 Basel (CH)
(72) Erfinder: Breidert, Stefan, 4313 Möhlin (CH); Sütterlin, Andreas, 4422 Arisdorf (CH); Hurni, Martin, 4125 Riehen (CH)
(74) Vertreter: OK pat AG

(57) **Zusammenfassung**

Ankopplungsvorrichtung (1) zum Ankoppeln von Rechnern (50) umfassend: einen Transportbehälter (10) und einen Lagerbehälter (30). Der Transportbehälter (10) umfassend: eine Adaptereinheit umfassend eine untere Konnektorschiene (14) mit unteren Konnektoren (14.1 - 14.4); ein gerastertes Vorderstück (12) und ein gerastertes Hinterstück (11), welche Einstellbereiche (15.1 - 15.4) für die Rechner (50) bilden. Das gerasterte Vorderstück (12) bietet eine erste Variabilität (A), um die Einstellbereiche (15.1 - 15.4) an die Grösse der anzukoppelnden Rechner (50) anpassen zu können; und die untere Konnektorschiene (14) bietet eine zweite Variabilität (B), sodass die unteren Konnektoren (14.1 - 14.4) auf die ersten Konnektoren (54) der anzukoppelnden Rechner (50) ausgerichtet werden können. Durch Einführen eines Rechners (50) in einem der Einstellbereiche (15.1 - 15.4), ein elektrischer Kontakt zwischen dem ersten Konnektor (54) und einem der unteren Konnektoren (14.1-14.2) herstellbar ist. Der Lagerbehälter (30) umfasst mindestens einen Aufnahmefach (31.1, 31.2) umfassend eine erste Konnektorschiene (36) mit ersten Konnektoren (36.1-36.4) zur Verbindung mit den anzukoppelnden Rechnern (50); und eine zweite Konnektorschiene (38) zur direkten Verbindung mit weiteren Konnektoren (58) der anzukoppelnden Rechner (50).

## Beschreibung

Die vorliegende Erfindung betrifft eine Ankopplungsvorrichtung zum Ankoppeln von Rechnern, vorzugsweise tragbaren Rechnern, die auf verschiedenen Seiten mit Konnektoren versehen sind. Die Ankopplungsvorrichtung ist insbesondere für das Ankopplen von Notebooks oder Tablet-Computern geeignet.

### HINTERGRUND DER ERFINDUNG

Vollverkabelte Rechnerräume oder Tagungsstätten sind teuer in der Installation und im Unterhalt. Teilweise beachtliche Strecken werden mit oft teuren Kabeln überbrückt. Dabei sind die als Rechnerräume ausgerüsteten Räumlichkeiten durch das vorhandene Mobiliar praktisch nur noch als Rechnerräume nutzbar und können nicht flexibel einer anderen Nutzung zugeführt werden. Im weiteren kann bei Bedarf aufgrund der aufwendigen Verkabelung nicht auf einen anderen Raum ausgewichen werden.

Durch die Verwendung mobiler Informatik-Aufbewahrungssysteme findet der Inhalt eines kompletten Informatikraums Aufnahme in einem mobilen Lagerbehälter. Somit ist es möglich eine moderne, den Bedürfnissen angepasste Computer-Infrastruktur in jedem beliebigen Schul- oder Seminarraum anzubieten. Je nach Bedürfnis und Teilnehmerzahl an einer Schulung oder Tagung kann flexibel die benötigte Infrastruktur in einem beliebigen Raum zur Verfügung gestellt werden.

Verschiedene mobile Informatik-Aufbewahrungssysteme oder Ankopplungsvorrichtungen sind bekannt, die eine Reihe von Rechnern aufnehmen. Das Schweizer Patent CH698383 des Anmelders der vorliegenden Anmeldung offenbart ein Aufbewahrungssystem mit mehreren Transportbehältern (Einschubelementen), die seitlich aus einem Lagerbehälter herausziehbar angeordnet sind. Die Transportbehälter haben Einstellbereiche, die ein individuelles, vertikal geführtes Hochkant-Einstellen der Rechner ermöglichen, wobei die rückwärtigen Seiten der Rechner in die Richtung des Inneren des Lagerbehälters weisen. Es ist eine Konnektoranordnung innerhalb des Lagerbehälters befestigt, die je einen Steckbereich für jeden der Rechner aufweist. Nach dem Einstellen der Lagerbehälter wird der Transportbehälter samt den Rechnern horizontal in den Lagerbehälter eingeschoben. Beim manuellen Einschieben wird zwischen den elektrischen Verbindungsmitteln der Rechner und der Konnektoranordnung durch das horizontale Einschieben des Transportbehälters eine elektrische Verbindung hergestellt.

Es wird als ein Nachteil der bekannten Aufbewahrungssysteme angesehen, dass die Ankopplungsvorrichtungen und deren Transportbehälter stets für ein bestimmtes Modell von Rechnern konfiguriert sind. Weil es keinen Standard für die Anordnung von Konnektoren an Rechnern gibt, ist es notwendig die Positionierung der Konnektoranordnung der Transportbehälter und des Lagerbehälters je nach anzukoppelndem Rechner anzupassen. Dies führt zu einer grossen Einschränkung der Anwendbarkeit dieser Systeme und die fehlende Flexibilität hat die Ausbreitung dieser Systeme behindert.

### ZU LÖSENDE TECHNISCHE AUFGABE

Es stellt sich daher die Aufgabe, eine Ankopplungsvorrichtung zum Ankoppeln von Rechnern bereitzustellen, die sich leicht an verschiedene Rechner anpassen lässt und dadurch eine erhöhte Flexibilität bietet, während die elektrischen Ankopplungsfunktionen gewährleistet sind.

Die Ankopplungsvorrichtung muss nicht nur an die verschiedenen Anordnungen von elektrischen Kontaktpunkten der Rechner, sondern auch an die Grösse der Rechner konfigurierbar sein.

### OFFENBARUNG DER ERFINDUNG

Die oben identifizierte technische Aufgabe der Erfindung wird durch eine Ankopplungsvorrichtung gelöst, die mindestens einen Transportbehälter zum Ankoppeln der Rechner umfasst, die in einen Lagerbehälter eingeschoben wird und damit eine elektrische Verbindung zwischen den im Transportbehälter angeordneten Rechnern und im Lagerbehälter montierten Lade- und/oder Netzwerkkomponenten ermöglicht. Der Transportbehälter zum Ankoppeln der Rechner umfasst: eine Adaptereinheit mit einer unteren Konnektorschiene mit Konnektoren zur Verbindung mit Konnektoren der anzukoppelnden Rechner; ein gerastertes Vorderstück und ein gerastertes Hinterstück, die Einstellbereiche für die Rechner bilden, die in Bezug auf die Konnektoren der gerasterten Konnektorschiene ausgerichtet sind. Beim Einführen eines Rechners in einen der Einstellbereiche wird ein elektrischer Kontakt zwischen einem Konnektor des Rechners und einem der unteren Konnektoren hergestellt.

Die Ankopplungsvorrichtung umfasst ferner einen Lagerbehälter zur Aufnahme eines oder mehrerer Transportbehälter mit mindestens einem Aufnahmefach umfassend: eine erste Konnektorschiene mit ersten Konnektoren zur Verbindung mit den anzukoppelnden Rechnern mittels entsprechender Konnektoren der Adaptereinheit und eine zweite Konnektorschiene mit Konnektoren zur direkten Verbindung mit weiteren Konnektoren der anzukoppelnden Rechner. Durch Einführen des Transportbehälters in eines der Aufnahmefächer wird eine elektrische Verbindung zwischen den im Transportbehälter angeordneten Rechnern und im Lagerbehälter montierten Lade- und/oder Netzwerkkomponenten hergestellt.

Die Ankopplungsvorrichtung der vorliegenden Erfindung ist dadurch gekennzeichnet, dass das gerasterte Vorderstück eine erste Variabilität bietet, um die Einstellbereiche an die Grösse der anzukoppelnden Rechner anpassen zu können; und dass die untere Konnektorschiene eine zweite Variabilität bietet, sodass die Konnektoren der unteren Konnektorschiene auf Konnektoren der anzukoppelnden Rechner ausgerichtet werden können.

### VORTEILHAFTE WIRKUNGEN

Der wichtigste Vorteil der Erfindung ist, dass sowohl die Transportbehälter als auch die gesamte Ankopplungsvorrichtung an die verschiedensten Rechner ohne grossen Aufwand anpassen lässt.

Die entsprechende Konfigurierbarkeit bringt den Vorteil mit sich, dass die Ankopplungsvorrichtung sehr flexibel in unterschiedlichen Bereichen Einsatz finden kann.

### KURZE BESCHREIBUNG DER ZEICHNUNGEN

Die erfindungsgemässe Ankopplungsvorrichtung wird nun an Hand von schematischen, den Umfang der Erfindung nicht beschränkenden Zeichnungen von beispielhaften Ausführungsformen im Detail erläutert.
- Fig. 1: zeigt einen schematischen Perspektiv-Querschnitt des Gesamtsystems der Ankopplungsvorrichtung gemäss Erfindung, wobei die inneren Elemente sichtbar sind;
- Fig. 2A: zeigt eine schematische Perspektiv-Draufsicht eines Transportbehälters gemäss Erfindung;
- Fig. 2B: zeigt eine schematische Perspektiv-Unteransicht eines Transportbehälters gemäss Erfindung;
- Fig. 2C: zeigt eine schematische Seitenansicht eines Transportbehälters gemäss Erfindung;
- Fig. 2D: zeigt eine schematische Rückansicht eines Transportbehälters gemäss Erfindung;
- Fig. 2E: zeigt eine schematische Untersicht eines Transportbehälters gemäss Erfindung, wobei zwei angekoppelte Rechner - nicht Teil der Erfindung - gezeigt sind;
- Fig. 2F: zeigt eine schematische Rückansicht eines Transportbehälters gemäss Erfindung, die zeigt, wie ein Rechner in einen der Einstellbereiche eingeführt wird;
- Fig. 3: zeigt eine schematische Seitenansicht des Gesamtsystems der Ankopplungsvorrichtung gemäss Erfindung, die darstellt, wie ein Transportbehälter in eines der Aufnahmefächer eingeschoben wird;
- Fig. 4: zeigt eine schematische Detail-Seitenansicht des mit einem Kreis I umgrenzten Bereichs der Ankopplungsvorrichtung, wobei Details der ersten Konnektorschiene und der Adaptereinheit sichtbar sind;
- Fig. 5: zeigt eine schematische Perspektiv-Ansicht eines Teils eines Aufnahmefaches der Lagerbehälter, wobei Details der Nockenführung und der Konnektorschienen sichtbar sind.

- *Anmerkung:*: *Die Figuren sind teilweise nicht massstabgerecht dargestellt. Der Massstab der Zeichnungen soll keine einschränkende Wirkung auf die Erfindung haben.*

### DETAILLIERTE BESCHREIBUNG DER BEVORZUGTEN AUSFÜHRUNGSFORMEN

Im Folgenden werden vorteilhafte Ausführungsformen der Erfindung beschrieben, wobei es sich um beispielhafte Ausführungsformen handelt. Diese umfassen sowohl verschiedene Ausbildungen der Gesamterfindung, als auch Baugruppen und Einzelteile der Erfindung. Grundsätzlich lassen sich die beschriebenen Baugruppen und Einzelteile der verschiedenen Ausführungsformen miteinander kombinieren, respektive die Baugruppen und Einzelteile einzelner Ausführungsformen lassen sich durch die Baugruppen und Einzelteile anderer Ausführungsformen ersetzen. Die hierbei gebildeten Kombinationen können kleinere, jedem Fachmann geläufige und daher nicht weiter beschriebene Anpassungen bedingen, zum Beispiel um ein Zusammenwirken oder Ineinandergreifen der Baugruppen und Einzelteile zu ermöglichen.

Der Einfachheit halber werden in den Figuren und der Beschreibung die selben Bezugszeichen für gleiche oder gleichartige Bauelemente und Komponenten verwendet.

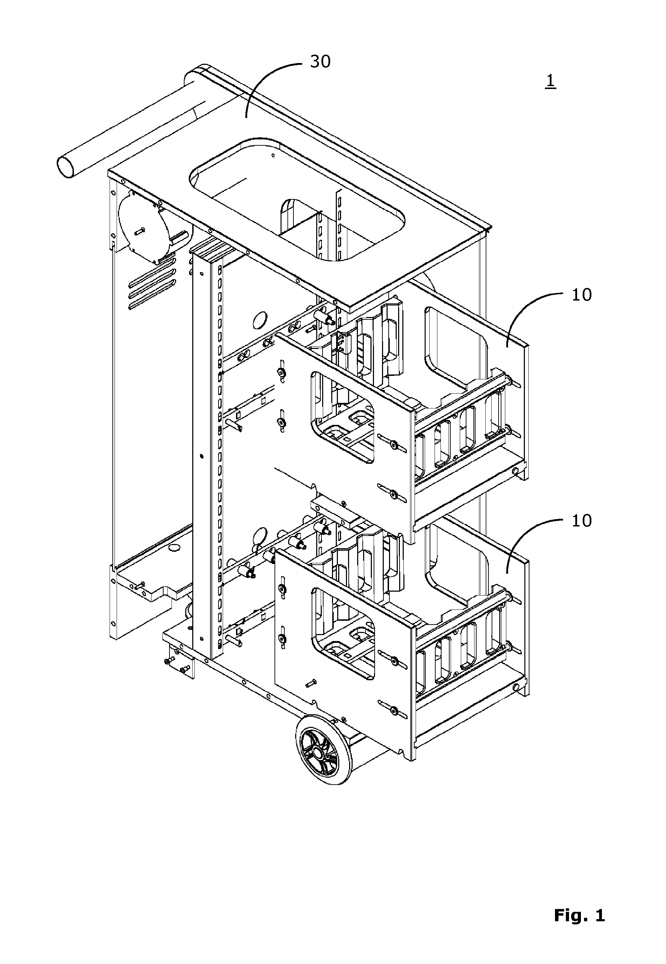

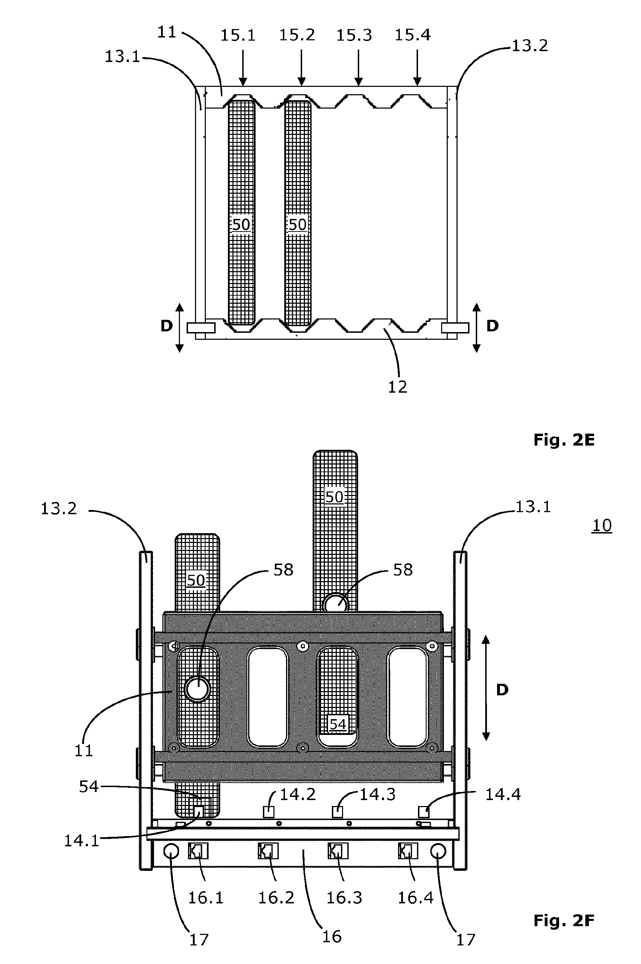

Im Zusammenhang mit Fig. 1 ist nun eine erste Ausführungsform der Erfindung näher erläutert. In Fig. 1 ist eine Ankopplungsvorrichtung 1 zum Ankoppeln von mehreren Rechnern 50 gezeigt. Ein solcher Rechner 50 (sichtbar in Figur 2E) weist typischerweise auf mehreren Seiten (aber mindestens an der Rückseite) angeordnete elektrische Konnektoren (z. B. zur Spannungsversorgung und zur Netzwerkverbindung) auf. Es gibt Rechner 50, die an einer rückwärtigen Seite elektrische Verbindungsmittel für die Netzwerkverbindung und an einer anderen Seite Verbindungsmittel für die Spannungsversorgung aufweisen bzw. vice-versa.

Der Begriff Konnektor umfasst in Zusammenhang mit der vorliegenden Erfindung alle Arten von Steckern/ Steckeraufnahmen, Buchsen, Kupplungen oder andere elektrische Verbindungsmittel. Die Interpretation dieses Begriffes soll nicht auf den spezifisch gewählten Begriff beschränkt werden. Konnektor bezieht sich vielmehr auf das allgemeine Konzept dahinter.

Die vorliegende Erfindung umfasst zweit Hauptkomponenten: mindestens einen Transportbehälter 10 zum Ankoppeln der Rechner 50 und einen Lagerbehälter 30 zur Aufnahme eines oder mehrerer Transportbehälter 10. Die Transportbehälter 10 sind aus dem Lagerbehälter 30 herausziehbar und dadurch separat transportabel oder z.B. in einem separaten Schrank einschliessbar. Die Lagerung des Transportbehälters 10 erfolgt vorzugsweise bei allen Ausführungsformen ähnlich wie bei einer Schublade, wobei darauf zu achten ist, dass die horizontale Bewegung des Transportbehälters 10 sehr genau erfolgt, damit, wie weiter unten erläutert wird, eine genaue und möglichst verspannungsfreie Verbindung zwischen Verbindungsmitteln der Rechner 50 und Konnektoranordnungen am Lagerbehälter 30 zustande kommen. Nach dem Einstellen der Rechner 50 wird der Transportbehälter 10 samt den Rechnern 50 in den Lagerbehälter 30 eingeschoben. Beim Einschieben wird eine direkte elektrische Verbindung zwischen den im Transportbehälter 10 angeordneten Rechnern 50 und im Lagerbehälter 30 montierten Lade- und/oder Netzwerkkomponenten hergestellt.

Die in Fig. 1 gezeigte Ankopplungsvorrichtung 1 beinhaltet zwei Transportbehälter 10. In jedem Transportbehälter 10 kann eine bestimmte Anzahl tragbarer Rechner 50 untergebracht werden. Der Lagerbehälter 30 umfasst vorzugsweise ein Fahrgestell mit Rollen, wodurch er nach Bedarf problemlos von Raum zu Raum verschoben werden kann. Das Fahrgestell umfasst mindestens drei Räder, wobei sich Ausführungsformen mit vier Rädern besonders bewährt haben. Wenn die Räder dreh- oder lenkbar ausgeführt sind, lässt sich die Vorrichtung 10 problemlos um enge Kurven bewegen.

Die Ankopplungsvorrichtung 1 ist mobil, kompakt und handlich. Die komplette IT-Ausstattung eines Informatikraumes kann in der Ankopplungsvorrichtung 1 Aufnahme finden und es wird somit eine kabellose Infrastruktur in jedem Schul- oder Schulungsraum ermöglicht.

Gemäss Erfindung sind alle Geräte, inklusive der Rechner 50 unter sicherem Verschluss. Zu diesem Zweck kann/können die Ankopplungsvorrichtung 1 und/oder die Lagerbehälter 30 und/oder die Transportbehälter 10 bei allen Ausführungsformen verschliessbar ausgeführt sein. Ferner können alle Rechner 50 automatisch durch die Ladekomponenten aufgeladen werden.

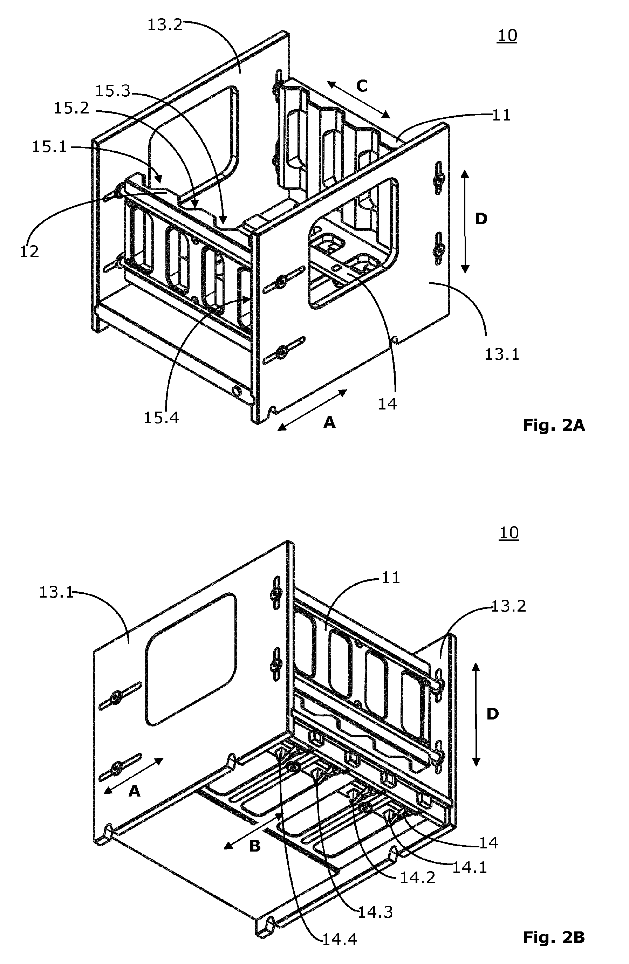

In den Figuren 2A bis 2E sind Details einer möglichen Ausführungsform des Transportbehälters 10 gezeigt. Diese Transportbehälter 10 sollten einerseits möglichst leicht sein. Andererseits sollten sie ausreichende Stabilität bieten, um ein problemloses und verspannungsfreies Herstellen der elektrischen Verbindungen zu ermöglichen. Der Transportbehälter 10 kann wie eine Schublade ausgeführt sein, der zwei Behälterseiten 13.1, 13.2, ein gerastertes Vorderstück 12 und ein gerastertes Hinterstück 11 aufweist. Die Behälterseiten 13.1, 13.2 können Ausnehmungen oder Aussparungen aufweisen, um das Gewicht zu reduzieren, und um eine gute Belüftung (mit oder ohne Lüfter) sicherstellen zu können. In Fig. 2E sind ein speziell geformtes gerastertes Vorderstück 12 und gerastertes Hinterstück 11 zu erkennen. Diese erlauben das vertikal geführte Hochkant-Einstellen der tragbaren Rechner 50 und geben gleichzeitig eine bestimmte Position der Rechner 50 vor, um beim horizontalen Einschieben der Transportbehälter 10 in den Lagerbehälter 30 die Herstellung der elektrischen Verbindung zu Lade- und/oder Netzwerkkomponenten zu ermöglichen.

Fig. 2A zeigt eine schematische Perspektiv-Draufsicht eines Transportbehälters 10 gemäss Erfindung. Der Transportbehälter 10 ist von zwei Behälterseiten 13.1, 13.2, einem gerasterten Vorderstück 12 und einem gerasterten Hinterstück 11 definiert. Wie in der Figur 2A zu erkennen ist, weist der Transportbehälter 10 zueinander benachbarte Einstellbereiche 15.1-15.4 auf, die ein individuelles, vertikal geführtes Hochkant-Einstellen der tragbaren Rechner 50 ermöglichen. Vorzugsweise sind das speziell geformte Vorderstück 12 und Hinterstück 11 mit einer weichen Oberfläche versehen, um ein Verkratzen der Rechner 50 zu verhindern. Der Begriff "gerastert" wird im Zusammenhang mit der vorliegenden Patenanmeldung verwendet, um zu betonen, dass das Vorderstück 12 und Hinterstück 11 eine gerasterte Struktur haben, die es ermöglicht, die Rechner in einem gewissen Raster(-abstand) anzuordnen. Vorzugsweise hat das Vorderstück 12 und Hinterstück 11 eine mäander-ähnliche Form, welche die Einstellbereiche 15.1 - 15.4 für die Rechner 50 bilden. Besonders bevorzugt sind Ausführungsformen mit 4 oder 5 Einstellbereichen 15.1-15.4 pro Transportbehälter 10. In der bevorzugten Ausführungsform der Erfindung sind die Mäander-Strukturen des Hinterstücks 11 und/oder des Vorderstücks 12 konisch angefertigt, somit die Einstellbereiche 15.1 - 15.4 für Rechner 50 mit unterschiedlichen Dicken verwendet werden können.

Bei diesem Hochkant-Einstellen der Rechner 50 - wenn der Transportbehälter 10 in dem Lagerbehälter 30 eingeschoben ist - weisen die rückwärtigen Seiten der Rechner 50 in die Richtung des Inneren des Lagerbehälters 30. Die Einstellbereiche 15.1-15.4 erlauben ein problemloses und sanftes Hineinstellen der Rechner 50.

Wie in den Figuren 2A und 2B mit einem Doppelpfeil A illustriert, bietet das gerasterte Vorderstück 12 eine erste Variabilität A, um die Einstellbereiche 15.1 - 15.4 an die Grösse der anzukoppelnden Rechner 50 anpassen zu können. Vor dem Hochkant-Einstellen der Rechner 50 erlaubt die erste Variabilität A eine Anpassung der Einstellbereiche 15.1 - 15.4 an die Breite des Rechners 50. Je nach Positionierung der Rechner 50 in den Einstellbereichen 15.1 - 15.4, ist eine Anpassung an verschiedene Abmessungen der Rechner 50 möglich.

Der Begriff Variabilität bedeutet in der vorliegenden Beschreibung und den Ansprüchen eine Einstellmöglichkeit, die ohne spezielle Werkzeuge, ohne jede Veränderung der Hardwarestrukturen (d. h. ohne Bohren, Biegen oder Strecken, etc.) und ohne Austausch irgendeiner Komponente der Ankopplungsvorrichtung 1 durchgeführt werden kann. Die Variabilität ist vorzugsweise eine stufenlose kontinuierliche Variabilität der entsprechenden Teile/ Parameter, die ohne Fachkenntnisse selbst vom Endbenutzer vorgenommen werden kann.

In den illustrierten Ausführungsformen der Erfindung wird die Variabilität durch eine Schraube, die in einem Langloch verschoben werden kann, und eine Befestigung (z. B. Schraubenmutter) zum Feststellen der eingestellten Parameter realisiert. Andere Mittel sind aber auch möglich, wie z. B. vordefinierte Befestigungslöcher oder andere Schiebvorrichtungen, die zum Beispiel mit Rastpositionen versehen sein können.

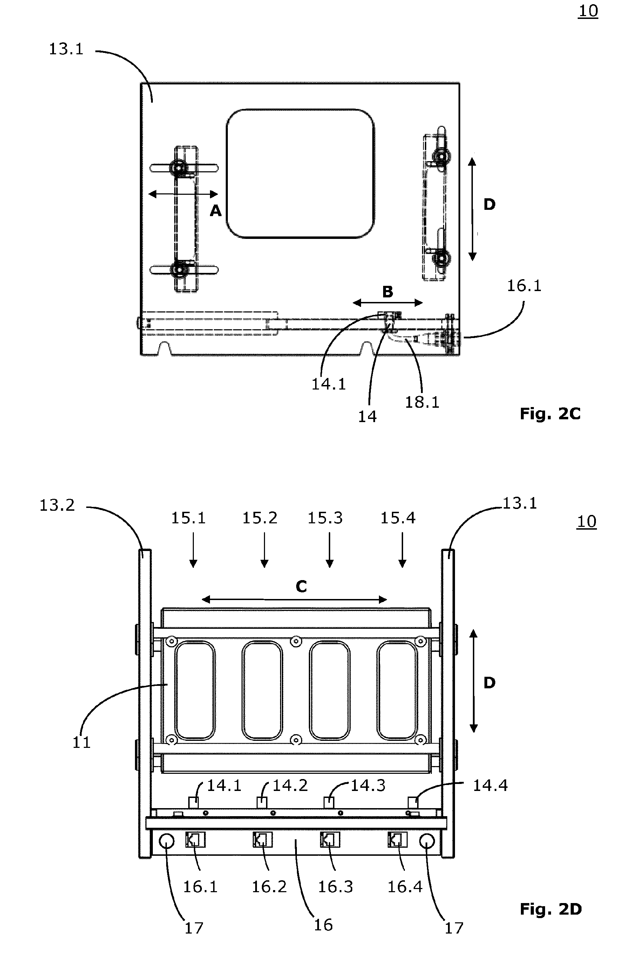

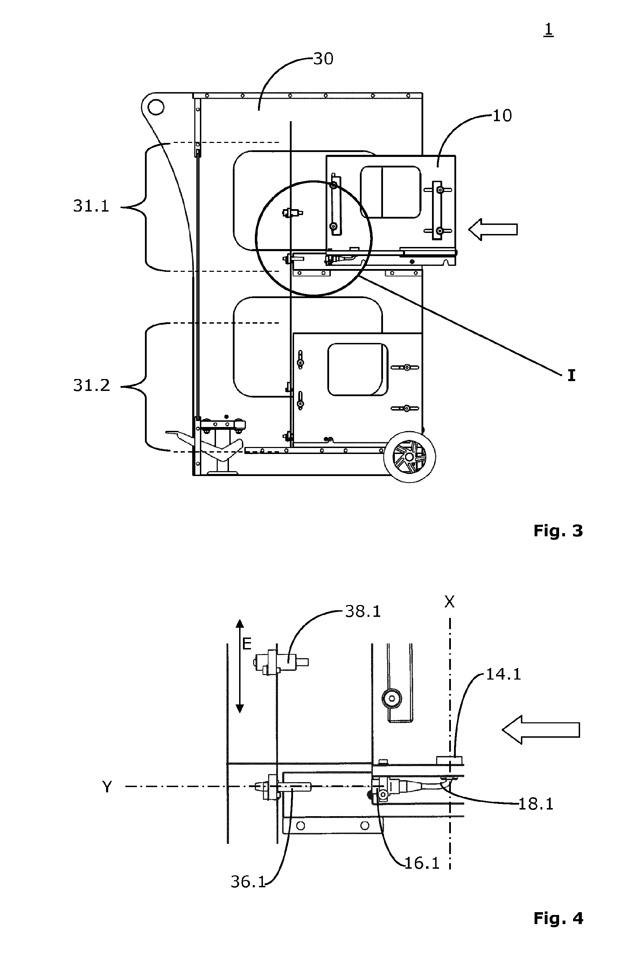

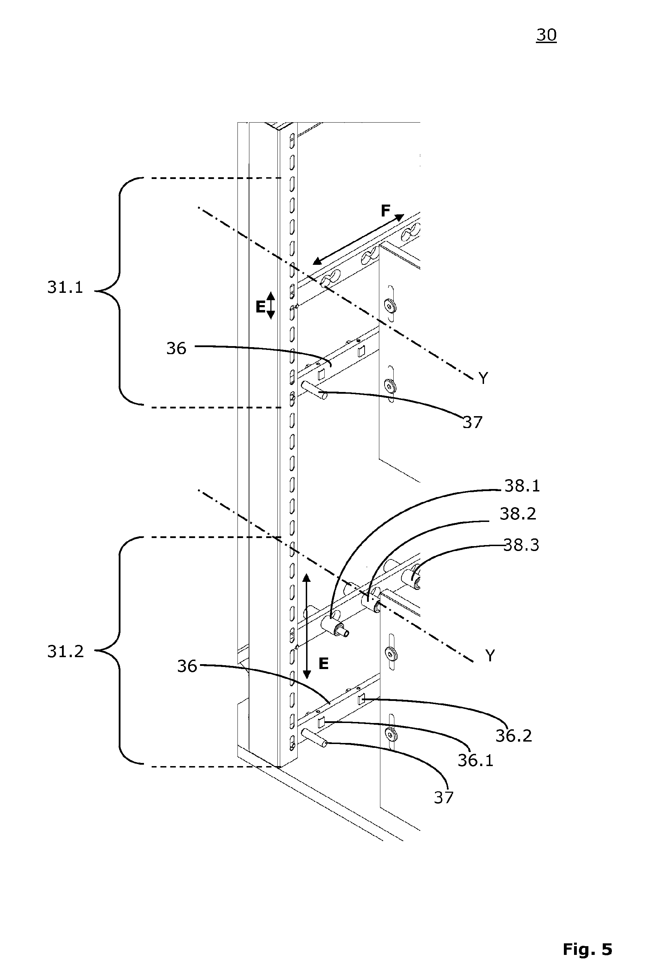

Der Transportbehälter 10 umfasst eine Adaptereinheit mit einer unteren Konnektorschiene 14. Die untere Konnektorschiene 14 ist mit je einem unteren Konnektor 14.1-14.4 für jeden der Einstellbereiche 15.1-15.4 versehen. Wie in den Figur 2D gut zu erkennen ist, umfasst die Adaptereinheit je einen hintere Konnektor 16.1-16.4 für jeden unteren Konnektor 14.1-14.4. Die Adaptereinheit ermöglicht, das elektrische Verbindungen an verschiedenen Seiten der Rechner 50 mit im Lagerbehälter 30 montierten Lade- und/oder Netzwerkkomponenten hergestellt werden können. In den illustrierten Ausführungsformen bilden z.B. die unteren Konnektoren 14.1 - 14.4 zur Verbindung mit Konnektoren der anzukoppelnden Rechner 50 mit den hinteren Konnektoren 16.1-16.4 einen rechten Winkel, sodass - beim Einführen des Transportbehälters 10 in eines der Aufnahmefächer 31.1, 31.2 - sowohl der an der rückwärtigen Seite befindliche Stromkonnektor als auch der an der anderen Seite des Rechners 50 befindliche Konnektor verbunden werden können. Mit anderen Worten dient die Adaptereinheit dazu, die anverschiedenen Seiten der Rechner 50 befindlichen Konnektoren planparallel miteinander auszurichten, sodass beim Einschieben des Transportbehälters 10 in eines der Aufnahmefächer 31.1, 31.2 alle dieser Konnektoren der Rechner 50 mit im Lagerbehälter 30 montierten Lade- und/oder Netzwerkkomponenten verbunden werden können. Der Lagerbehälter 30 umfasst entsprechende Konnektoren 36.1-36.4, die in Zusammenhang mit den Figuren 4 und 5 beschrieben werden.

Fig. 2B zeigt eine schematische Perspektiv-Untersicht eines Transportbehälters 10 gemäss Erfindung. Wie in den Figuren 2B und 2C mit einem Doppelpfeil B illustriert ist, bietet die untere Konnektorschiene 14 eine zweite Variabilität B, sodass die unteren Konnektoren 14.1 - 14.4 der unteren Konnektorschiene 14 auf erste Konnektoren 54 der anzukoppelnden Rechner 50 ausgerichtet werden können. Vorzugsweise läuft diese Variabilität B senkrecht zu der unteren Konnektorschiene 14 und auch zu dem Hinterstück 11 / Vorderstück 12. Damit ist die Variabilität B im Wesentlichen parallel zu der Variabilität A.

Fig. 2C stellt eine schematische Seitenansicht eines Transportbehälters 10 gemäss Erfindung dar, wobei die Variabilität B der unteren Konnektorschiene 14 gut erkennbar ist. In der bevorzugten Ausführungsform werden die unteren Konnektoren 14.1-14.4 mit den hinteren Konnektoren 16.16-16.4 durch ein flexibles Verbindungselement 18.1 - 18.4 (z.B. ein mehradriges Kabel) verbunden, um die Variabilität B nicht zu behindern.

Wie in der Figur 2D, die eine schematische Rückansicht des Transportbehälters 10 zeigt, mit einem Doppelpfeil C illustriert, bieten das gerasterte Vorderstück 12 und das gerasterte Hinterstück 11 vorzugsweise eine dritte Variabilität C, die zu der Konnektorschiene 14 parallel und zu den Behälterseiten 13.1, 13.2 senkrecht verläuft. Die dritte Variabilität C ermöglicht, die Einstellbereiche 15.1 - 15.4 in Bezug zu der unteren Konnektorschiene 14 auszurichten und in Parallelität mit der ersten Behälterseite 13.1 und der zweiten Behälterseite 13.2 des Transportbehälters 10 zu bringen.

Fig. 2E zeigt eine schematische Unteransicht des Transportbehälters 10 gemäss Erfindung, wobei zwei angekoppelte Rechner 50 schematisch gezeigt sind. Die mäander-ähnliche Form des Vorderstücks 12 und Hinterstücks 11 und die dadurch geformten Einstellbereiche 15.1 - 15.4 für Rechner 50 sind in dieser Figur gut erkennbar.

In Fig. 2F, die eine schematische Rückansicht des Transportbehälters 10 zeigt, ist zu sehen, wie Rechner 50 in Einstellbereiche 15.1 - 15.4 von oben her senkrecht eingeführt werden. Wie hier illustriert, wird durch Einführen des Rechners 50 in einen der Einstellbereiche 15.1 - 15.4 ein elektrischer Kontakt zwischen einem ersten Konnektorplatz 54 des Rechners 50 und einem der unteren Konnektoren 14.1-14.2 der Konnektorschiene 14 hergestellt.

In Figur 2F ist auch eine Nockenführung 17 zu sehen, die in einer bevorzugten Ausführungsform der Erfindung vorgesehen ist, um im Zusammenwirken mit einer Nocke 37 - die in Figur 5 zu sehen ist - das Einführen des Transportbehälters 10 in eines der Aufnahmefächer 31.1, 31.2 des Lagerbehälters 30 zu unterstützen, dadurch, dass - beim Einführen des Transportbehälters 10 in eines der Aufnahmefächer 31.1, 31.2 - die Nockenführung 17 mit der Nocke 37 einrastet. Damit können die ersten Konnektoren 36.1-36.4 der ersten Konnektorschiene 36 des Lagerbehälters 30 mit den hinteren Konnektoren 16.1-16.4 der Adaptereinheit und/oder die weiteren Konnektoren 58 der anzukoppelnden Rechner 50 mit den Konnektoren 38.1-38.4 der zweiten Konnektorschiene 38 ausgerichtet werden.

Vorzugsweise wird je ein Paar von Nockenführungen 17 per Transportbehälter 10 vorgesehen.

In Figur 2F ist auch zu erkennen, dass das gerasterte Hinterstück 11 vorzugsweise eine vierte Variabilität D bietet, die zu der Konnektorschiene 14 senkrecht verläuft. Diese vierte Variabilität D dient dazu das Verdecken von weiteren Konnektoren 58 der anzukoppelnden Rechner 50 durch das Hinterstück 11 verhindern zu können.

Fig. 3 zeigt eine schematische Seitenansicht des Gesamtsystems der Ankopplungsvorrichtung 1 gemäss Erfindung, wobei im gezeigten Moment ein Transportbehälter 10 in ein Aufnahmefach 31.1 eingeschoben wird (illustriert durch einen Blockpfeil). Wie in der Figur 3 zu sehen ist, sind die Transportbehälter 10 aus dem Lagerbehälter 30 herausziehbar und dadurch separat transportabel. Die Lagerung bzw. Bewegungsführung des Transportbehälters 10 erfolgt ähnlich wie bei einer Schublade, wobei darauf zu achten ist, dass die horizontale Bewegung des Transportbehälters 10 im Bezug zum Lagerbehälter 30 sehr genau erfolgt, damit eine genaue und möglichst verspannungsfreie Verbindung zwischen Verbindungsmitteln der Rechner 50 und Konnektoranordnungen am Lagerbehälter 30 zustande kommen. Nach dem Einstellen der Rechner 50 wird der Transportbehälter 10 samt den Rechnern 50 in den Lagerbehälter 30 eingeschoben. Beim Einschieben wird eine direkte elektrische Verbindung zwischen den im Transportbehälter 10 angeordneten Rechnern 50 und im Lagerbehälter 30 montierten Lade- und/oder Netzwerkkomponenten hergestellt.

Das Einschieben der Transportbehälter 10 kann optional durch eine lineare Führung z. B. in Form eines Schubladenauszug, einer Rollenführung usw. erleichtert werden.

Fig. 4 zeigt eine schematische Detail-Seitenansicht des in Figur 3 mit einem Kreis I umgrenzten Bereichs der Ankopplungsvorrichtung 1, wobei Details der ersten Konnektorschiene 36 des Lagerbehälters 30 und der Adaptereinheit sichtbar sind. In dieser Figur 4 ist zu sehen, wie die unteren Konnektoren 14.1-14.4 mit den hinteren Konnektoren 16.16-16.4 durch flexible Verbindungselemente 18.1 - 18.4 elektrisch verbunden sind.

In der Figur 4 ist auch zu sehen, wie die Adaptereinheit die Einführrichtung X der Rechner 50 in den Transportbehälter 10 in der Einschubrichtung Y des Transportbehälters 10 transformiert. Diese Transformierung der Einführrichtung X wird mittels der unteren Konnektoren 14.1-14.4, der flexiblen Verbindungselemente 18.1 - 18.4 und der hinteren Konnektoren 16.16-16.4 realisiert. Dies ermöglicht, das elektrische Verbindungen an verschiedenen Seiten der Rechner 50 mit im Lagerbehälter 30 montierten Lade- und/oder Netzwerkkomponenten hergestellt werden können. Die in Figur 4 illustrierten Einschubrichtung Y und Einführrichtung X schliessen einen rechten Winkel ein. Dank der flexiblen Verbindungselemente 18.1-18.4 sind je nach anzukoppelnden Rechner aber auch andere Winkel zwischen Einschubrichtung Y und Einführrichtung X realisierbar.

Zur Aufnahme der hinteren Konnektoren 16.1 - 16.4 umfasst jedes Aufnahmefach 31.1, 31.2 je eine erste Konnektorschiene 36 mit ersten Konnektoren 36.1 - 36.4. Die ersten Konnektoren 36.1 - 36.4 des Aufnahmefaches 31.1, 31.2 sind so (kollinear) ausgerichtet, dass beim Einschieben des Transportbehälters 10 eine elektrische Verbindung zwischen den hinteren Konnektoren 16.1 - 16.4 und den ersten Konnektoren 36.1 - 36.4 hergestellt wird.

Fig. 5 zeigt eine schematische Perspektiv-Ansicht eines Teils des Aufnahmefaches 31.1 der Lagerbehälter 30, wobei Details der Nockenführung 17 und der Konnektorschienen 36, 38 sichtbar sind.

Je eine zweite Konnektorschiene 38 ist für jeden der Aufnahmefächer 31.1, 31.2 vorgesehen zur direkten Verbindung mit weiteren Konnektoren 58 der Rechner 50, die essentiell parallel mit der Einschubrichtung Y ausgerichtet sind.

Wie in den Figuren 4 und 5 mit einem Doppelpfeil E illustriert, bietet die zweite Konnektorschiene 38 des Lagerbehälters 30 vorzugsweise eine fünfte Variabilität E, die zu der Konnektorschiene 38 senkrecht verläuft. Die fünfte Variabilität E dient dazu die zweiten Konnektoren 38.1-38.4 in Bezug zu den weiteren Konnektoren 58 der anzukoppelnden Rechner 50 auszurichten. Diese fünfte Variabilität E wird - wie in Figur 5 zu sehen ist - entweder durch Langlöcher und/oder vorgefertigte Befestigungslöcher für die Aufnahme der zweiten Konnektorschiene 38 realisiert.

Figur 5 zeigt eine weitere sechste Variabilität F, die parallel mit der zweiten Konnektorschiene 38 läuft und es ermöglicht, die zweiten Konnektoren 38.1-38.4 in Bezug zu den weiteren Konnektoren 58 der anzukoppelnden Rechner 50 auszurichten. Die sechste Variabilität F ist optional und wird - wie in Figur 5 zu sehen ist - entweder durch Langlöcher und/oder vorgefertigte Befestigungslöcher für die Aufnahme der zweiten Konnektoren 38.1-38.4 realisiert.

In einer bevorzugten Ausführungsform der Erfindung - wobei sowohl die fünfte Variabilität E als auch die sechste Variabilität F vorhanden ist - wird eine zwei-dimensionale Einstellmöglichkeit der zweiten Konnektoren 38.1-38.4 ermöglicht.

In Figur 5 ist auch eine Nocke 37 zu sehen, die in einer bevorzugten Ausführungsform der Erfindung vorgesehen ist, um im Zusammenwirken mit der Nockenführung 17 - die in Figur 2F zu sehen ist - das Einführen des Transportbehälters 10 in eines der Aufnahmefächer 31.1, 31.2 des Lagerbehälters 30 zu unterstützen, dadurch dass - beim Einführen des Transportbehälters 10 in eines der Aufnahmefächer 31.1, 31.2 - die Nockenführung 17 mit dem Nocken 37 einrastet. Damit können die ersten Konnektoren 36.1-36.4 der ersten Konnektorschiene 36 des Lagerbehälters 30 mit den hinteren Konnektoren 16.1-16.4 der Adaptereinheit und/oder die weiteren Konnektoren 58 der anzukoppelnden Rechner 50 mit den Konnektoren 38.1-38.4 der zweiten Konnektorschiene 38 ausgerichtet werden. Vorzugsweise wird je ein Paar Nocken 37 per Aufnahmefach 31.1, 31.2 vorgesehen.

Es wird davon ausgegangen, dass auf der Grundlage der hier beschriebenen spezifischen Struktur viele Variationen vorgenommen werden können, ohne über den Rahmen der Erfindung, wie in den folgenden Ansprüchen definiert, hinauszugehen.

### REFERENZLISTE:

| | |
|---|---|
| Ankopplungsvorrichtung | 1 |
| Transportbehälter | 10 |
| Hinterstück | 11 |
| Vorderstück | 12 |
| erste Behälterseite | 13.1 |
| zweite Behälterseite | 13.2 |
| untere Konnektorschiene | 14 |
| untere Konnektor | 14.1-14.4 |
| Einstellbereiche | 15.1-15.4 |
| hintere Konnektor | 16.1-.16.4 |
| Nocke | 17 |
| Laqerbehälter | 30 |
| Aufnahmefach | 31.1, 31.2 |
| erste Konnektorschiene | 36 |
| erste Konnektoren | 36.1-36.4 |
| Nocke | 37 |
| zweite Konnektorschiene | 38 |
| zweite Konnektoren | 38.1-38.2 |
| Rechner | 50 |
| erster Konnektor (des Rechners) | 54 |
| weiterer Konnektor (des Rechners) | 58 |
| erste Variabilität | A |
| zweite Variabilität | B |
| dritte Variabilität | C |
| vierte Variabilität | D |
| fünfte Variabilität | E |
| sechste Variabilität | F |
| Einführrichtung (des Rechners) | X |
| Einschubrichtung (des Transportbehälters) | Y |

## Patentansprüche

1. Ankopplungsvorrichtung (1) zum Ankoppeln von Rechnern (50) umfassend:
- **einen Transportbehälter (10)** zum Ankoppeln der Rechner (50), wobei der Transportbehälter (10) umfasst:
- eine Adaptereinheit umfassend eine untere Konnektorschiene (14) mit unteren Konnektoren (14.1 - 14.4) zur Verbindung mit ersten Konnektoren (54) der anzukoppelnden Rechner (50);
- ein gerastertes Vorderstück (12) und ein gerastertes Hinterstück (11), welche Einstellbereiche (15.1 - 15.4) für die Rechner (50) bilden, die in Bezug auf die unteren Konnektoren (14.1 - 14.4) der unteren Konnektorschiene (14) ausgerichtet sind;
wobei das gerasterte Vorderstück (12) eine **erste Variabilität (A)** bietet, um die Einstellbereiche (15.1 - 15.4) an die Grösse der anzukoppelnden Rechner (50) anpassen zu können;
wobei die untere Konnektorschiene (14) eine **zweite Variabilität (B)** bietet, sodass die unteren Konnektoren (14.1 - 14.4) der unteren Konnektorschiene (14) auf die ersten Konnektoren (54) der anzukoppelnden Rechner (50) ausgerichtet werden können; und
wobei durch Einführen eines Rechners (50) in einen der Einstellbereiche (15.1 - 15.4), ein elektrischer Kontakt zwischen dem ersten Konnektor (54) des Rechners (50) und einem der unteren Konnektoren (14.1-14.2) herstellbar ist;
- **einen Lagerbehälter (30)** zur Aufnahme eines oder mehrerer Transportbehälter (10) mit mindestens einem Aufnahmefach (31.1, 31.2) umfassend:
- eine erste Konnektorschiene (36) mit ersten Konnektoren (36.1-36.4) zur Verbindung mit den ersten Konnektoren (54) der anzukoppelnden Rechner (50) mittels entsprechenden hinteren Konnektoren (16.1-16.4) der Adaptereinheit; und
- eine zweite Konnektorschiene (38) mit zweiten Konnektoren (38.1-38.4) zur direkten Verbindung mit weiteren Konnektoren (58) der anzukoppelnden Rechner (50);
wobei durch Einführen des Transportbehälters (10) in eines der Aufnahmefächer (31.1, 31.2), eine elektrische Verbindung zwischen den im Transportbehälter angeordneten Rechnern (50) und im Lagerbehälter (30) montierten Lade- und/oder Netzwerkkomponenten herstellbar ist.

2. Ankopplungsvorrichtung (1) nach Anspruch 1,
**dadurch gekennzeichnet, dass** das gerasterte Vorderstück (12) und das gerasterte Hinterstück (11) eine weitere, mit der Konnektorschiene (14) parallel laufende, dritte Variabilität (C) bieten, um die Einstellbereiche (15.1 - 15.4) in Bezug auf die untere Konnektorschiene (14) ausrichten und in Parallelität mit einer ersten Behälterseite (13.1) und einer zweiten Behälterseite (13.2) des Transportbehälters (10) bringen zu können.

3. Ankopplungsvorrichtung (1) nach einem der Ansprüche 1 oder 2,
**dadurch gekennzeichnet, dass** das gerasterte Hinterstück (11) eine weitere, zu der Konnektorschiene (14) senkrecht laufende, vierte Variabilität (D) bietet, um das Verdecken von weiteren Konnektoren (58) der anzukoppelnden Rechner (50) vorbeugen zu können.

4. Ankopplungsvorrichtung (1) nach einem der Ansprüche 1 bis 3,
**dadurch gekennzeichnet, dass** die zweite Konnektorschiene (38) des Lagerbehälters (30) eine fünfte, zu der Konnektorschiene (38) senkrecht laufende Variabilität (E) bietet, um die zweiten Konnektoren (38.1-38.4) in Bezug zu Konnektoren der anzukoppelnden Rechner (50) ausrichten zu können.

5. Ankopplungsvorrichtung (1) nach einem der Ansprüche 1 bis 4,
**dadurch gekennzeichnet, dass** die zweite Konnektorschiene (38) des Lagerbehälters (30) eine weitere, mit der zweiten Konnektorschiene (38) parallel laufende sechste Variabilität (F) bietet, um die zweiten Konnektoren (38.1-38.4) in Bezug zu weitere Konnektoren (58) der anzukoppelnden Rechner (50) ausrichten zu können.

6. Ankopplungsvorrichtung (1) nach einem der Ansprüche 1 bis 5,
**dadurch gekennzeichnet, dass** das Einführen des Transportbehälters (10) in eines der Aufnahmefächer (31.1, 31.2) durch eine Nockenführung (17) und eine Nocke (37) unterstütz wird, um die ersten Konnektoren (36.1-36.4) der ersten Konnektorschiene (36) mit den hinteren Konnektoren (16.1-16.4) der Adaptereinheit und/oder die weiteren Konnektoren (58) der anzukoppelnden Rechner (50) mit den Konnektoren (38.1-38.4) der zweiten Konnektorschiene (38) richten zu können, wobei bei Einführen des Transportbehälters (10) in eines der Aufnahmefächer (31.1, 31.2), die Nocke (37) mit der Nockenführung (17) einrastet.

7. Ankopplungsvorrichtung (1) nach Anspruch 6,
**dadurch gekennzeichnet, dass** je ein Paar von Nockenführungen (17) per Transportbehälter (10) und je ein Paar Nocken (37) per Aufnahmefach (31.1, 31.2) vorgesehen ist.

8. Ankopplungsvorrichtung (1) nach einem der Ansprüche 1 bis 7,
**dadurch gekennzeichnet, dass:**
- die ersten Konnektoren (54) der anzukoppelnden Rechner (50) essenziell parallel auf der Einführrichtung (Y) der Rechner (50) in den Transportbehälter (10) angeordnet sind;
- die weiteren Konnektoren (58) der anzukoppelnden Rechner (50) essenziell parallel auf der Einschubrichtung (X) des Transportbehälters (10) in eines der Aufnahmefächer (31.1, 31.2) angeordnet sind;
wobei die Einführrichtung (Y) und Einschubrichtung (X) zueinander essentiell senkrecht in essentiell der gleichen Ebene laufen; und wobei die Adaptereinheit die Einführrichtung in der Einschubrichtung (Y) des Transportbehälters (10) transformiert.

9. Ankopplungsvorrichtung (1) nach einem der Ansprüche 1 bis 8,
**dadurch gekennzeichnet, dass:**
- die ersten Konnektoren (54) der anzukoppelnden Rechner (50) Netzwerk-Verbindungstellen - vorzugsweise RJ45 Buchsen sind; und
- die weiteren Konnektoren (58) der anzukoppelnden Rechner (50) Ladeverbindungsstellen sind.

10. Ankopplungsvorrichtung (1) nach einem der Ansprüche 1 bis 8,
**dadurch gekennzeichnet, dass:**
- die ersten Konnektoren (54) der anzukoppelnden Rechner (50) Ladeverbindungsstellen sind; und
- die weiteren Konnektoren (58) der anzukoppelnden Rechner (50) Netzwerk-Verbindungstellen - vorzugsweise RJ45 Buchsen sind.
